# EUROPEAN PATENT APPLICATION

(11) **EP 2 210 696 A1**
(43) Date of publication of application: **28.07.2010**
(21) Application number: 09290050.5
(22) Date of filing: 26.01.2009
(51) Int. Cl.: B23K 26/00, B23K 26/03

(54) **Method and apparatus for irradiating a semiconductor material surface by laser energy**

(71) Applicant: Excico France, 92230 Gennevilliers (FR)
(72) Inventor: Venturini, Julien, 75011 Paris (FR)
(74) Representative: BiiP cvba

(57) **Abstract**

The present invention is related to a method for irradiating semiconductor material comprising: irradiating a region of a semiconductor material layer surface with a first laser having laser irradiation parameters to melt at least a part of the region; and controlling the irradiation process by adapting the irradiation parameters; **characterized in that** the method further comprises determining the depth of the melted region part. Further, the present invention is related to an apparatus for irradiating semiconductor material comprising: a first laser for irradiating a region of a semiconductor layer surface to melt at least a part of the region, said laser having laser irradiation parameters; and a controller for controlling the irradiation process by adapting the laser irradiation parameters; **characterized in that** the apparatus further comprises means for determining the depth of the melted region part.

## Description

### FIELD OF THE INVENTION

The present invention relates to a method of irradiating a semiconductor material surface by means of a laser. Further, it relates to a laser apparatus for irradiating a semiconductor material surface.

### BACKGROUND OF THE INVENTION

Laser irradiation of semiconductor material surfaces is well known for applications such as thermal annealing of amorphous silicon to obtain re-crystallization, and/or dopant activation. This technique offers significant advantages over a conventional heating process by enabling a very fast heat treatment and shallow depth of the heated region.

A general problem of a laser irradiation process is that it is very difficult to control with high accuracy, since it depends on a number of variable parameters such as variations in semiconductor material to be treated, variations in laser beam energy, scattering, etc. For example, in some conventional laser irradiation process, the output energy of the laser is controlled, but consequently this type of control does not account for loss of energy between the laser and the semiconductor material surface to be treated, variations in the semiconductor material itself and variations in laser pulse shape. These variations result in non-uniformity between different treated surface regions and non-uniform and unreliable electronic device performance.

In an attempt to solve the above problem, laser irradiation methods are described wherein the process is monitored at the level of the semiconductor material surface. For example, US 2004/0023418 describes an annealing method wherein the reflectivity of a laser pre-pulse on the material surface to be treated is measured and put in a feed back circuit to control the amplitude of the irradiation source.

A clear drawback of the above pre-pulse monitoring is that it is not as effective as a real-time control of the irradiation process. Further, the pre-pulse is time consuming and consequently not cost effective.

Other examples are laser irradiation methods wherein the temperature of the material surface is monitored in real-time.

The drawback of temperature monitoring is that it is a technique in which satisfying accuracy is very difficult to achieve in case of an irradiation process using laser pulses of less than a millisecond.

In an attempt to solve the latter difficulty, US 2005/0199596 describes a laser crystallization apparatus wherein melting and crystallization is monitored in real-time by observing the light reflected by the treated material region in a time period in the range of several hundreds of nanoseconds and less. The reflectivity changes of the treated region are magnified and imaged and can be used for feeding back.

A clear drawback of the above method is that the laser irradiation process is observed and measured through images, which makes time-resolved measurement in the order of micro- or nanoseconds impossible.

An additional problem in the state-of-the-art is that the beam size diameters used in the laser irradiation process are very small and therefore difficult to probe.

Considering the drawbacks of the above laser irradiation processes, it is a first object of the present invention to provide a laser irradiation method and apparatus having accurate real-time monitoring at the level of the semiconductor material surface, resulting in uniformity between different treated surface regions and uniformity and reliability in electronic device performance.

It is a further object of the present invention to provide a laser irradiation method and apparatus which is cost-effective and less time consuming.

Another object of the present invention is to provide a laser irradiation method and apparatus which is adapted for real-time monitoring in case of very short laser pulse irradiation.

It is also an object of the present invention to provide a laser irradiation method and apparatus adapted for easily using the monitoring results in a feed back circuit, resulting in effective stabilization of the irradiation process.

The present invention meets the above objects by determining the melting depth of the semiconductor layer region

### SUMMARY OF THE INVENTION

The present invention is directed to a method for irradiating semiconductor material comprising:
- irradiating a region of a semiconductor material layer surface with a first laser having laser irradiation parameters to melt at least a part of the region;
- and controlling the irradiation process by adapting the irradiation parameters;
**characterized in that** the method further comprises determining the depth of the melted region part.

Further, the present invention is directed to an apparatus for irradiating semiconductor material comprising:
- a first laser for irradiating a region of a semiconductor layer surface to melt at least a part of the region, said laser having laser irradiation parameters;
- and a controller for controlling the irradiation process by adapting the laser irradiation parameters;
**characterized in that** the apparatus further comprises means for determining the depth of the melted region part.

### BRIEF DESCRIPTION OF THE DRAWINGS

FIG 1 illustrates an embodiment of a method in accordance to the present invention.
FIG 2A illustrates a preferred embodiment of a method in accordance to the present invention.
FIG 2B illustrates another preferred embodiment of a method in accordance to the present invention.
FIG 3 illustrates the link between melting time and the depth of the melted region part.
FIG 4 illustrates an embodiment of an apparatus in accordance to the present invention.
FIG 5 illustrates a further embodiment of an apparatus in accordance to the present invention.
FIG 6 shows a plot of the melting time as a function of energy density.

### DESCRIPTION OF THE INVENTION

A person skilled in the art will understood that the embodiments described below are merely illustrative in accordance with the present invention and not limiting the intended scope of the invention. Other embodiments may also be considered.

According to a first embodiment of the present invention a method for irradiating semiconductor material is provided comprising:
- irradiating a region of a semiconductor material layer surface with a first laser having laser irradiation parameters to melt at least a part of the region;
- and controlling the irradiation process by adapting the irradiation parameters;
**characterized in that** the method further comprises determining the depth of the melted region part.

By determining the depth of the melted region part, the laser irradiation process may be monitored accurately in real-time at the level of the semiconductor material surface, resulting in uniformity between different treated surface regions and uniformity in electronic device performance.

The semiconductor material layer may be of any material suitable for semiconductor applications such as, but not limited to undoped silicon, doped silicon, implanted silicon, crystalline silicon, amorphous silicon, silicon germanium, germanium nitride, III-V compound semiconductors such as gallium nitride, silicon carbide, and the like.

In accordance with the present invention, a laser irradiation method is provided wherein the irradiation process may be controlled by adapting the irradiation parameters based on comparing the determined depth of the melted region part to a target depth. The target depth may be determined empirically or by modeling based on the required device performance.

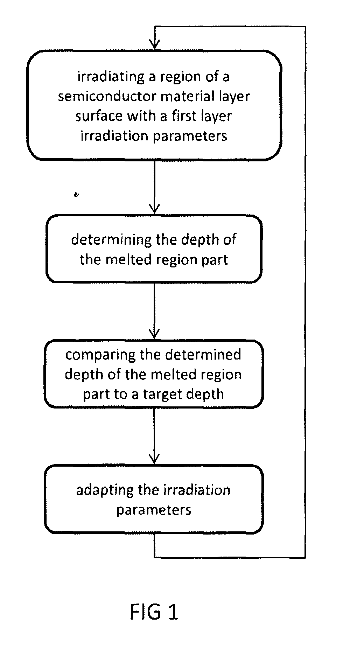

As illustrated in FIG 1, by comparing the determined depth of the melted region part to a target depth, the monitoring results may be easily used in a feed back circuit, resulting in effective stabilization of the irradiation process. Further, it is clear that effective stabilization may lead to a laser irradiation process which is improved in terms of process uniformity, cost-effectiveness and time consumption.

The first laser may be any pulsed laser whose wavelength, output energy and pulse duration are such that the irradiate d region can be melted. Such laser may be for example a Xenon-Chloride excimer laser. The laser irradiation parameters of the first laser are adapted to melt the material and achieve the required energy density. The energy of the first laser may typically be about 10 Joules with a beam size diameter of about 4 cm² to achieve about 2,5 Joules / cm²). The pulse duration of the first laser may typically be in the range of about 100 ns to about 200 ns which may be a compromise between fast temperature ramp up to achieve fusion but slow enough to limit undesirable defect generation due to explosive boiling.

Adapting the laser irradiation parameters may be done by adjusting the output energy of the laser. For example, in case the first laser is an excimer laser, the voltage applied to the gas discharge may be changed.

By adapting the laser irradiation parameters, the depth of the melted region part is influenced, thereby directly influencing the quality of that region part after resolidification. For example by adapting the laser irradiation parameters, crystal size and amount of defects in the re-solidified region part may be controlled.

In accordance with the present invention, determining the depth of the melted region part may comprise measuring the melting time of the irradiated surface during irradiation. In the context of the present invention, the melting time is defined as the duration of the melting phase, i.e. the period of time during which the irradiated region part is molten. The duration of the melting phase may be determined by measuring the change of the refractive index when at least a part of the irradiated region melts, than re-solidifies.

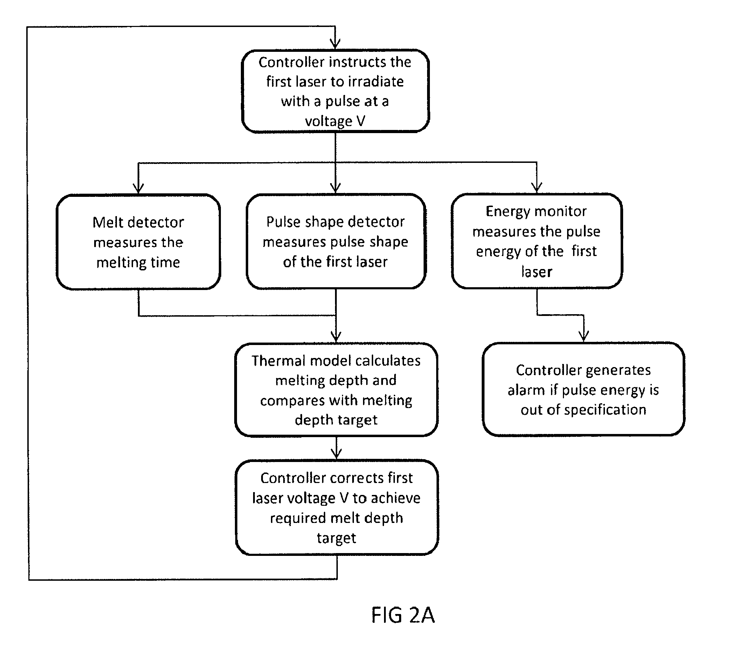

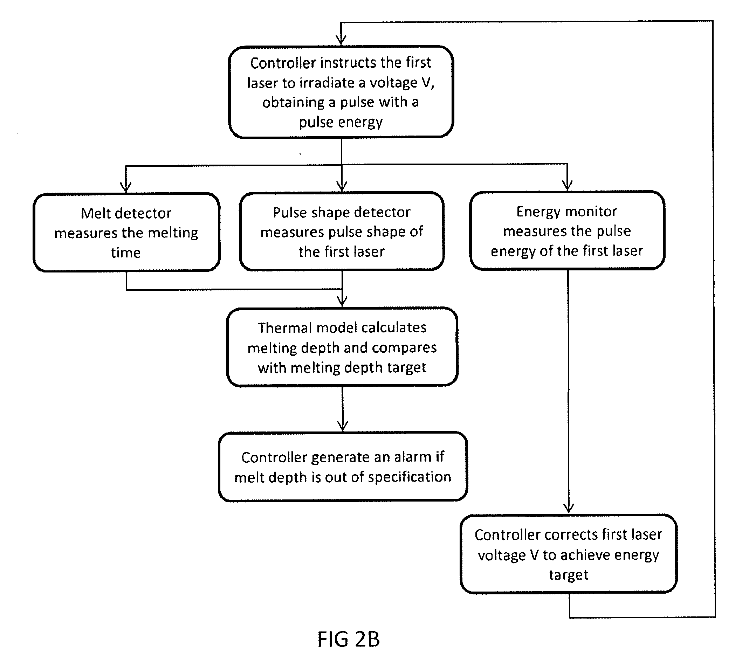

FIG 2A and 2B illustrate two methods in accordance with the present invention comprising a feed back circuit wherein the depth of the melted region part is determined by measuring the melting time of the irradiated surface during irradiation.

FIG 2A describes a feedback loop where the difference between the melting depth of the melted region part and the target depth is used as input to adapt the first laser voltage. An alarm is generated if the first laser energy is out of specification, indicating severe deviation in process or equipment performance.

FIG 2B describes a feed back loop where the first laser pulse energy is controlled by adapting first laser voltage. The difference between the melting depth of the melted region part and the target depth is used as input to generate an alarm if it is out of specification, indicating severe deviation in process or equipment performance.

In a further method in accordance with the present invention, a feed-forward controlling step may be used wherein the depth of the melted region part is determined and characterized as a function of voltage and pulse duration of the first laser prior to full processing of the surface region to be irradiated, such that during full processing the dept of the melted region part may be controlled to a desired value or a set of desired values.

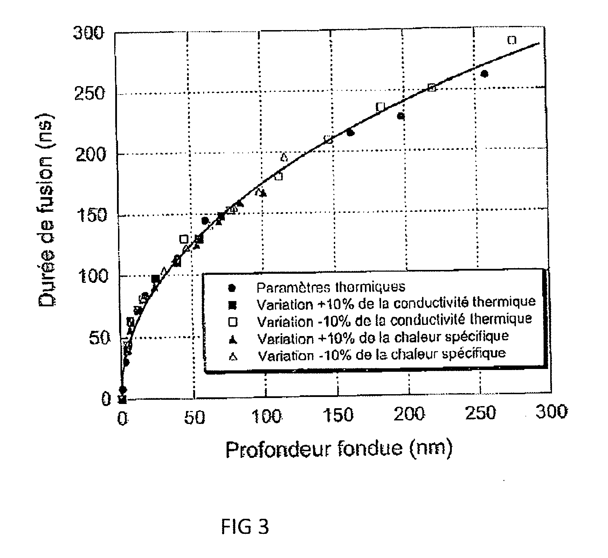

The depth of the melted region part is determined based on the melting time and known characteristics of the semiconductor layer surface region and the first laser. Therefore the melting time, the pulse shape of the first laser, as well as optical and thermal characteristics of the semiconductor layer surface region may be put into a thermal modeling tool to determine the melting depth. This may be done either by real-time calculation or by using a look-up table which links melting time to melt depth and which is defined prior to the processing, as illustrated in FIG 3.

As an alternative of determining the depth of the melted region part by measuring the melting time, the depth of the melted region part may be determined by using time-resolved interferometry or ellipsometry as well.

In a preferred embodiment in accordance with the present invention, a method for irradiating semiconductor material is provided, wherein measuring the change of the refractive index of the irradiated surface may comprise measuring the reflectivity of the irradiated surface during irradiation, or may comprise an ellipsometric measurement. Measuring the reflectivity may comprise a reflection intensity measurement.

By determining the depth of the melted region part by reflection measurements, the laser irradiation method may be used for real-time monitoring, even in case of very short laser pulse irradiation.

In accordance with the present invention, an embodiment is provided wherein measuring the reflectivity may comprise detecting the reflection from the first laser on the irradiated surface. In order to measure the part of the irradiation from the first laser which is reflected by the irradiated surface region, the angle of incidence of the first laser with respect to the surface should be non zero. A reflection detector may be positioned such that it is able to monitor this reflection. The reflectivity change may be measured by subtracting the normalized signal of the reflected beam and the incident beam of the first laser.

In an alternative embodiment in accordance with the present invention, measuring the reflectivity may comprise detecting the reflection from a second laser on the irradiated surface. The second laser may be any continuous laser whose wavelength is such that reflectivity changes significantly when the irradiated region part changes from solid to molten state and vice versa. Preferably, the second laser may be a continuous laser emitting in the red region of the visible spectrum, for example a continuous laser diode emitting in red. The second laser is directed towards the surface to be treated such that its beam reflects on the surface within the irradiated region irradiated by the first laser.

To improve the signal to noise of the reflection measurement, a series of reflection detections may be performed and used to determine the melting time.

Another embodiment according to the present invention provides a method for irradiating semiconductor material wherein controlling the irradiation process may comprise detecting the pulse shape of the first laser.

Further in accordance with present invention, an apparatus for irradiating semiconductor material is provided comprising:
- a first laser for irradiating a region of a semiconductor layer surface to melt at least a part of the region, said laser having laser irradiation parameters;
- and a controller for controlling the irradiation process by adapting the laser irradiation parameters;
**characterized in that** the apparatus further comprises means for determining the depth of the melted region part.

In an embodiment according to the present invention, an apparatus for irradiating a semiconductor material is provided wherein the controller may be adapted to control the irradiation process by adapting the irradiation parameters based on a comparison of the determined depth of the melted region part to a target depth.

In accordance with the present invention, the means for determining the depth of the melted region part may comprise means for measuring the melting time of the irradiated surface during irradiation. The means for measuring the melting time may comprise means for measuring the change in refractive index of the irradiated surface during irradiation.

As an alternative of means for measuring the melting time, a time-resolved interferometer or ellipsometer may be used as well.

In a preferred embodiment in accordance with the present invention, the means for measuring the change of the refractive index of the irradiated surface may comprise means for measuring the reflectivity of the irradiated surface during irradiation, or means adapted to perform an ellipsometric measurement. The means for measuring the reflectivity may be adapted to perform a reflection intensity measurement.

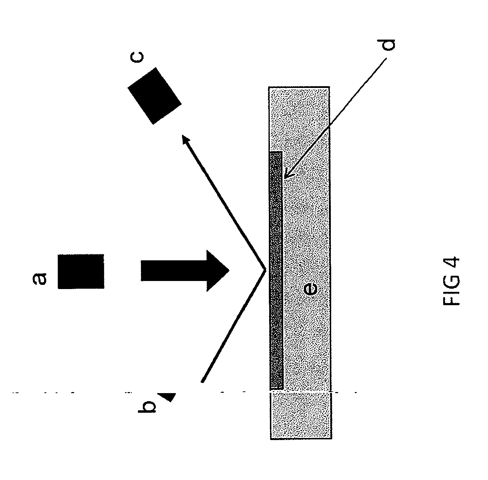

Further in accordance with the present invention and as illustrated in FIG 4, an apparatus for irradiating semiconductor material (e) is provided wherein the means for measuring the reflectivity of the irradiated surface (d) may comprise a reflection detector (c). The reflection detector may be for example a silicon photodiode and is positioned to monitor the reflected beam of the first laser (a) or the second laser as described above (b).

In a further embodiment in accordance with the present invention, the means for measuring the reflectivity of the irradiate surface may comprise an array of second lasers and an array of reflection detectors. Such array of second lasers and array of reflection detectors may provide information on the homogeneity of the melting depth or may help to resolve more securely the melting depth in cases wherein different melting zones propagate at the same time but at different depth in the semiconductor material, as usually occurs in for example re-crystallizing amorphous silicon.

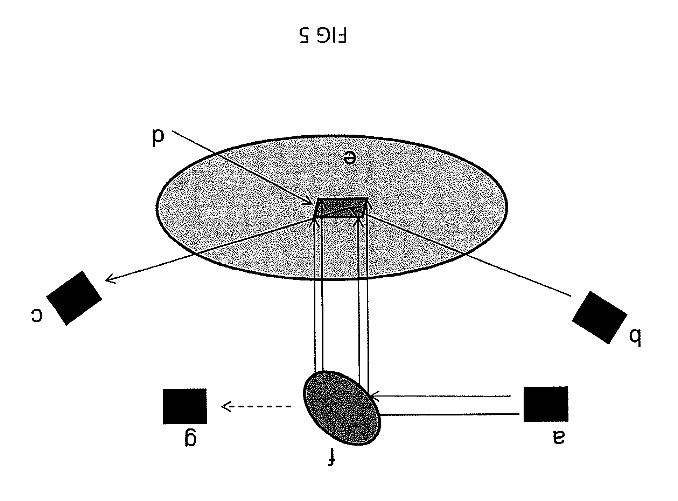

In another embodiment according to the present invention and as illustrated in FIG 5, an apparatus for irradiating semiconductor material is provided wherein the controller may comprise a pulse shape detector (g) for measuring the pulse shape of the first laser (a). The pulse shape detector may be for example a silicon photodiode. Measuring the pulse shape may be done by detecting the light leaking through one of the mirrors (f) directing the beam from the first laser to the surface region to be irradiated (d).

Further in another embodiment according to the present invention, the controller may comprise a variable attenuator for attenuating the first laser. Such variable attenuator may be formed of optical plates whose angle with respect to the first laser beam can be adjusted to change the beam energy inciding on the irradiated surface region.

The method and apparatus of the present may be used for making semiconductor material, such as substrates and devices. The method and apparatus may be applied for example in:
- recrystallization of amorphous semiconductor material
- repairing crystal damage or defects, caused by for example implantation
- dopant activation: see example 1
- controlled double implant activation: see example 2
- detecting non-conform semiconductor material: a shift of the melting time or the melt depth while keeping the same irradiation parameters may indicate a shift in material or material quality of the semiconductor layer.
- Detecting non-conform processes prior to the laser annealing step: a melting time shift or melt depth shift may be used as a passive monitoring during laser irradiation that may help to control the quality of processes prior to laser annealing. For example, if an oxide layer or another layer is present on top of the surface to be melted and is liable to a melting time shift while keeping the melting depth the same, the uniformity of said layer may be controlled and may gain an alarm if desired.

### Example 1:

### Melting time determination:

The processing laser is a high energy Xenon-Chloride Excimer laser, emitting at 308 nm. Its irradiated region is rectangular with a surface is between 2 and 4 cm² and the energy density on the irradiated region is between 2 to 6 Jouies/cm². Those parameters are chosen in order to achieve melting of the irradiated region on the wafer.

A diagnostic laser being a laser diode emitting continuously in the red region of the spectrum at 632 nm, is directed on the wafer at a position within the planned irradiated region. The reflection of the laser beam off the surface of the wafer is captured by a detector, for example a silicon photodiode.

As the processing laser irradiates the wafer, the signal from the detector is digitized by a data acquisition card (oscilloscope or equivalent) and the digitized signal is read by the control system. Due to the change in reflectivity of silicon, the signal increases when the silicon melts and decreases as it solidifies. The control system calculates the melting time as the "full width at half-maximum" of the digitized signal. The calculated melting time is logged by the control system and made available to the user for every laser shot.

### Process optimization:

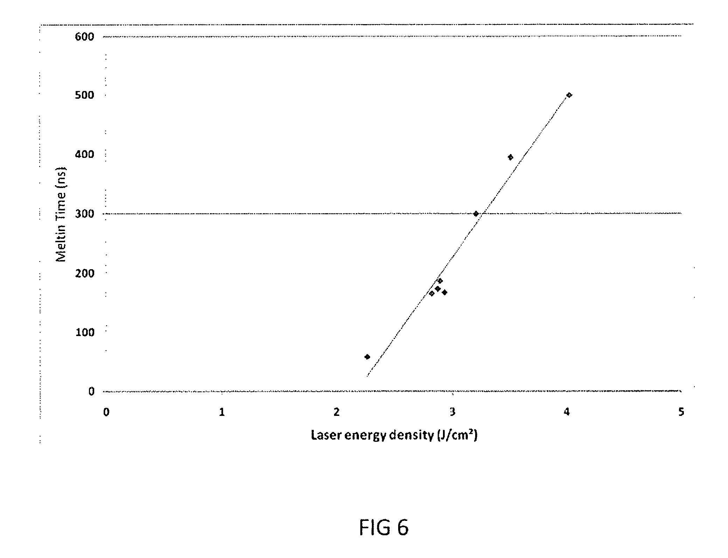

A first step is to establish the melting depth corresponding to the process performance required by the user. This can be done by irradiating an implanted test wafer while varying the laser energy density and monitoring the melting time. As a result, one can plot the melting time as a function of energy density as illustrated in FIG 6.

After irradiation of the test wafer, the desired output, usually surface resistivity, is measured, enabling the user to identify the desired operating point corresponding to a target melting depth and target energy. Another possible desired output may be the dopant diffusion, which is following exactly the melting depth extent and which can be measured by SIMS (Secondary Ion Mass Spectroscopy).

### Process monitoring and control:

During long term operation of the laser equipment, the output energy of the processing laser is maintained equal to the target energy by adjusting the voltage delivered to the gas discharge. The melting time, logged by the control system is monitored and averaged over multiple shots to minimize its variation. If the difference between the melting depth measured and the target value established during the process optimization is larger than a pre-determined threshold (+/- 5% for example), the control system generates an alarm that can trigger a re-optimization of the process.

### Example 2:

For some applications, two species of dopants are implanted in the silicon at different depth. A typical example is an IGBT device (Insulated-gate bipolar transistor) where boron is implanted near the surface to create a collector layer p and phosphorus is implanted deeper to create an n+ buffer layer.

The current invention enables controlled activation of both species by the same laser shot, because it makes it possible to control the melt depth such that the liquid/solid interface is at the transition between the two implanted species.

In this case, the boron layer will be annealed in liquid phase, providing the high activation rate required. With the same laser pulse, due to heat diffusion into the depth of the material, the phosphorus layer will also be annealed while staying in solid phase. Controlling the melt depth at the boron-phosphorus interface is important to avoid mixing of the two species, which indeed would occur in liquid phase due to the high diffusion coefficient in liquid silicon.

It is known that while liquid phase enables complete activation in one laser shot due to the high diffusion of dopants in silicon, activation in solid phase is a cumulative process that requires a "thermal budget" (i.e. a certain time at a certain temperature). Therefore, depending on the density of phosphorus atoms to be activated, it may be advantageous applying multiple shots for the same area, while always controlling the melt depth at the interface between the two dopants. In this case, the activation in phosphorus (solid phase) will be increased by each laser shot while the activation of boron will just be maintained at the level obtained after a single shot. One can also think of combining one laser shot at such energy that the melt depth is at the interface between the two dopant species and subsequent laser shots at an energy below the melt threshold for completing the phosphorus activation.

## Claims

1. A method for irradiating semiconductor material comprising:
- irradiating a region of a semiconductor material layer surface with a first laser having laser irradiation parameters to melt at least a part of the region;
- and controlling the irradiation process by adapting the irradiation parameters;
**characterized in that** the method further comprises determining the depth of the melted region part.

2. A method for irradiating a semiconductor material according to claim 1, wherein the irradiation process is controlled by adapting the irradiation parameters based on comparing the determined depth of the melted region part to a target depth.

3. A method for irradiating semiconductor material according to claims 1 to 2, wherein determining the depth of the melted region part comprises measuring the melting time of the melted region part during irradiation.

4. A method for irradiating semiconductor material according to claim 3, wherein measuring the melting time of the melted region part comprises measuring the change in refractive index of the irradiated surface during irradiation.

5. A method for irradiating semiconductor material according to claim 4, wherein measuring the melting time of the melted region part comprises measuring the reflectivity of the irradiated surface during irradiation.

6. A method for irradiating semiconductor material according to claim 5, wherein measuring the reflectivity comprises detecting the reflection from the first laser on the irradiated surface.

7. A method for irradiating semiconductor material according to claim 5, wherein measuring the reflectivity comprises detecting the reflection from a second laser on the irradiated surface.

8. An apparatus for irradiating semiconductor material comprising:
- a first laser for irradiating a region of a semiconductor layer surface to melt at least a part of the region, said laser having laser irradiation parameters;
- and a controller for controlling the irradiation process by adapting the laser irradiation parameters;
**characterized in that** the apparatus further comprises means for determining the depth of the melted region part.

9. An apparatus for irradiating semiconductor material according to claim 8, wherein the controller is adapted to control the irradiation process by adapting the irradiation parameters based on a comparison of the determined depth of the melted region part to a target depth.

10. An apparatus for irradiating semiconductor material according to claims 8 to 9, wherein the means for determining the depth of the melted region part comprises means for measuring the melting time of the melted region part during irradiation.

11. An apparatus for irradiating semiconductor material according to claim 10, wherein the means for measuring the melting time of the melted region part comprises means for measuring the change of refractive index of the irradiated surface during irradiation.

12. An apparatus for irradiating semiconductor material according to claim 11, wherein the means for measuring the melting time of the melted region part comprises means for measuring the reflectivity of the irradiated surface during irradiation.

13. An apparatus for irradiating semiconductor material according to claim 12, wherein the means for measuring the reflectivity of the irradiated surface comprise a second laser.

14. Use of an apparatus according to claims 8 to 13 for making semiconductor material.
